# EUROPEAN PATENT APPLICATION

(11) **EP 1 553 627 A1**
(43) Date of publication of application: **13.07.2005**
(21) Application number: 05002607.9
(22) Date of filing: 12.04.2001
(51) Int. Cl.: H01L 23/373, H01L 23/14, B22F 3/26, C22C 1/04, H01L 21/48

(54) **Material for a heat dissipation substrate for mounting a semiconductor and a ceramic package using the same**

(30) Priority: 14.04.2000 JP 2000113006; 07.12.2000 JP 2000372405
(62) Divisional of application: 01919912.4
(71) Applicant: A.L.M.T. CORP., Tokyo 110-0014 (JP)
(72) Inventor: Osada, Mitsuo c/o Allied Tech Inc., Sakata-shi Yamagata 998-0114 (JP); Hirayama, Norio c/o Allied Tech Inc., Sakata-shi Yamagata 998-0114 (JP); Arikawa, Tadashi c/o Allied Tech Inc., Sakata-shi Yamagata 998-0114 (JP); Amano, Yoshinari c/o Allied Tech Inc., Sakata-shi Yamagata 998-0114 (JP); Maesato, Hidetoshi c/o Allied Tech Inc., Sakata-shi Yamagata 998-0114 (JP); Hayashi, Hidefumi c/o Allied Tech Inc., Sakata-shi Yamagata 998-0114 (JP); Murai, Hiroshi c/o Allied Tech Inc., Sakata-shi Yamagata 998-0114 (JP)
(74) Representative: Hering, Hartmut, Dipl.-Ing.

(57) **Abstract**

A material for a semiconductor-mounting heat dissipation substrate comprises a copper-molybdenum rolled composite obtained by impregnating melted copper into a void between powder particles of molybdenum powder compact to obtain a composite of molybdenum and copper and then rolling the composite. The material for a semiconductor-mounting heat dissipation substrate is superior in thermal conductivity to a CMC clad material and easy in machining by a punch press. The substrate material is used in a heat dissipations substrate (13) of a ceramic package (11).

## Description

This invention relates to a material for use in a heat dissipation substrate for a semiconductor in the fields of IC, microwaves, and optics and, in particular, to a heat dissipation substrate for mounting a semiconductor device, a ceramic package comprising a heat dissipation substrate made of a material for a semiconductor-mounting heat dissipation substrate.

Traditionally, a heat dissipation member for use in applications of the type is required to have an excellent heat conductivity and to have a coefficient of thermal expansion approximate to that of alumina (Al₂O₃), beryllia (BeO), or aluminum nitride (AIN) which is a main constituent material of the semiconductor or the package.

For the applications of the type, use has presently been made of a composite alloy obtained by sintering a compact of tungsten powder in a hydrogen atmosphere to produce a porous tungsten (W) material and impregnating the material with copper (Cu).

In recent years, the semiconductor is operated at a higher frequency and increased in capacity. This brings about a situation where the copper- tungsten composite alloy limited in heat conductivity is insufficient. Specifically, in case of a ceramic package using alumina as an insulator, the package is assembled by bonding alumina and a heat dissipation substrate by a silver brazing alloy. However, in order that the coefficient of thermal expansion of the composite alloy has a value approximate to that of alumina in a temperature range between normal temperature and about 780 °C at which the silver brazing alloy is solidified, the ratio of copper in the copper-tungsten composite must be suppressed between 10 and 13%. Therefore, limitation is imposed upon the thermal conductivity.

This is because the thermal conductivity of the composite is determined by its composition. If any defect such as a void is not present in the material and if constituent metals do not make a solid solution so that no alloy is produced, the thermal conductivity is determined by the ratio of the constituent metals. However, if a metal making a solid solution with the constituent metals is added, the thermal conductivity is decreased.

In case of the copper-tungsten composite alloy used as the heat dissipation substrate of the ceramic package encapsulating the semiconductor, a very small amount of an iron-group metal such as nickel (Ni) is generally added. The addition of the iron-group metal is applied in order to improve the wettability and to facilitate infiltration of copper into a void or gap in the porous tungsten material. By the above-mentioned addition, the thermal conductivity is decreased as compared with the binary composite of copper and tungsten.

On the other hand, in case of a combination of molybdenum (Mo) and copper, addition of any other metal is unnecessary because melted copper is excellent in wettability to molybdenum. In addition, since molybdenum and copper make no substantial solid solution, the thermal conductivity of a composite thereof is determined by a volumetric ratio therebetween.

In the meanwhile, the present inventors have al ready proposed a composite which is obtained by press-molding molybdenum powder to produce a powder compact and impregnating the powder compact with copper and which is excellent in thermal conductivity and suitable as a heat dissipation substrate for a semiconductor used in a large-capacity inverter or the like (see Japanese Patent Application No. 9-226361, hereinafter called a prior art 1).

The composite obtained by the prior art 1 is good in rollability. It has also been proposed that a heat dissipation substrate of a greater size is obtained by a rolling process.

Recently, a large-capacity semiconductor device accompanied with generation of a large amount of heat is used in an increased number of applications. One example is an inverter of an automobile energized by electricity as a driving force. In this case, it is necessary to convert electric power of several tens watts. When a semiconductor device having a rectifying function is driven, a large amount of heat is generated. In order to release the heat through a radiator to the outside of a car system, use is generally made of a following structure.

A rectifying device is mounted on an insulator substrate (such as AIN). A plurality of similar insulator substrates are fixed and attached to a large-sized heat dissipation substrate by soldering. The heat dissipation substrate is fixed to the radiator by screws or the like. The heat dissipation substrate is required to have an excellent heat conductivity and to have a heat expansion characteristic such that deformation resulting tram a difference in coefficient of thermal expansion during cooling after soldering of the insulator substrates is suppressed small.

Furthermore, the heat dissipation substrate is required to have a sufficient strength to allow the substrate to be fixed to the radiator by the screws or the like. For the above-mentioned application, the present inventors have proposed a composite material of molybdenum and copper, which is manufactured without taking into account a rolling rate.

In view of energy saving in automobiles, there arises a demand for a heat dissipation substrate having a light weight in addition to the above-mentioned thermal characteristics. The light weight can be achieved by reducing the thickness of the heat dissipation substrate.

However, if the thickness of the heat dissipation substrate is reduced, the heat capacity is decreased. In addition, the deformation resulting from thermal strain due to the difference in coefficient of thermal expansion in case where the insulator substrates are soldered is increased as compared with the case where the thickness is great. The deformation is a hindrance to the contact between the substrate and the radiator and prevents transfer of the heat.

Thus, it is required to provide a material which is excellent in thermal conduction as compared with the composite material of molybdenum and copper according to the prior art 1 and which has a low coefficient of thermal expansion in a range such that occurrence of the problems related to the thermal strain upon soldering of the insulator substrates can be prevented.

For the above-mentioned application, AIN excellent in thermal conduction is generally used as the insulator substrate to be soldered to the heat dissipate substrate. During cooling after soldering the insulator substrate to the heat dissipation substrate, there arise problems, such as deformation of the heat dissipation substrate and fracture of the insulator substrate, as a result of the thermal strain. In order to prevent the occurrence of the above-mentioned problems, the material of the heat dissipation substrate is required to have a coefficient of thermal expansion of 9.0 x 10⁻⁶/K or less at a temperature of not higher than 400 °C. This is because, if the material having a coefficient higher than 9.0 x 10⁻⁶/K is used and if the dissipation substrate is soldered to ceramic such as AIN, deformation may be caused or cracks may be produced in a bonded portion of the ceramic itself during heat shrinkage.

On the other hand, apart from the application to the inverter of the electric automobile mentioned above, a ceramic package is used to mount a semiconductor device for producing microwaves in the field of communication or the like. In such ceramic package also, a heat dissipation substrate having following characteristics in addition to excellent thermal conduction is required in order to release heat produced by the semiconductor device to the outside of the package.

As the ceramic for the ceramic package, use is generally made of a material containing Al₂O₃ as a main component. For the heat dissipation substrate, it is required to use a material such that, in case where the substrate is bonded to the ceramic by a high-temperature (about 800 °C) brazing material (CuAg eutictic brazing material or the like), the ceramic is not broken and the heat dissipation substrate is less deformed during cooling after brazing due to the thermal strain resulting from the difference in coefficient of thermal expansion from the ceramic. In particular, in the event that the semiconductor device, such as GaAs, which produces high-temperature heat during operation and which is poor in thermal conduction is used, it is strongly desired to use a material excellent in thermal conduction at its surface to be contacted with the device. For this purpose, the Cu-W composite material generally used and the Mo-Cu composite material according to the prior art 1 may be insufficient in thermal conduction.

At present, use is sometimes made of a [Cu/Mo/Cu] clad material (hereinafter called CMC) in order to satisfy the above-mentioned requirement. However, the CMC clad material is disadvantageous in the following respects.

In the CMC clad material, a Cu layer as each surface layer is softened around a brazing temperature (800 °C) and is easily deformed during cooling. The clad material exhibits a thermal behavior similar to that of Mo. Therefore, as compared with the ceramic (generally containing Al₂O₃ as a main component) to be bonded, heat shrinkage is small so that the CMC composite is deformed. When the package is attached to a cooling device by screws or the like, the deformation prevents sufficient contact with the cooling device. Thus, there is a problem in cooling of the semiconductor.

Consideration will be made about mechanical characteristics of the substrate. Mo as an intermediate layer of the CMC clad material is brittle. Therefore, it a substrate part is punched out by a press from a plate material, cracks tend to occur in the Mo layer. In particular, the above-mentioned clad material has the soft Cu layers on both sides thereof. Therefore, it is difficult to prevent occurrence of the cracks in the Mo layer during punching In view of the above, the substrate part must be produced by electric spark machining which generally requires high machining cast.

On the other hand, Cu-W and Cu-Mo generally used as the heat dissipation substrate for the semiconductor ceramic package are typically bonded by the silver brazing alloy. Since W and Mo are poor in wettability with the silver brazing material, the surface of the Cu-W or Cu-Mo substrate is subjected to Ni plating. Thus, brazing with the ceramic subjected to metallization requires a Ni plating process for the substrate. In addition, various problems, such as blister, stain, and discoloration, will be caused due to insufficient contact of a Ni plating layer. reliability. Thus, there is a problem in yield or reliability.

In view of the above, it is a first object of this invention to provide a material for a semiconductor-mounting heat dissipation substrate which is for use as a heat dissipation substrate of a ceramic package.

It is a second object of this invention to provide a semiconductor-mounting heat dissipation substrate of a copper-clad type, which has a thermal expansion characteristic such that various problems resulting from thermal strain are not caused even if it is brazed with ceramic.

It is a third object of this invention to provide a ceramic package using the above-mentioned semiconductor-mounting heat dissipation substrate of a copper-clad type.

In order to achieve the above-mentioned objects, the present inventors have worked and found out, as a heat dissipation substrate of a ceramic package which is superior in thermal conductivity to a CMC clad material and easy in machining by a punch press, a [Cu/Mo-Cu-composite/Cu] clad material (CPC) which comprises a Mo-Cu composite decreased in coefficient of thermal expansion by increasing a working rate upon rolling and Cu layers affixed to both surfaces thereof and which has a thermal expansion characteristic such that various problems due to thermal strain do not occur even if it is brazed to ceramic. Thus, this invention has been made.

Specifically, according to this invention, there is provided a material for a semiconductor-mounting heat dissipation substrate, the material being a copper-molybdenum rolled composite obtained by infiltrating and filing (hereinafter may be referred to as impregnating) melted copper in a void or gap between powder particles of a molybdenum powder compact. Thereafter primary and secondars rolling in a first and a secondary rolling directions once or repeatedly has been performed, said first and second directions intersecting to each other, said rolled composite containing powder particles having a flat shape.

According to this invention, there is also provided a material for a semiconductor-mounting heat dissipation substrate of a copper-clad type, comprising a copper/copper-molybdenum composite/copper clad material formed by press-bonding copper plates to both surfaces of a rolled composite, the rolled composite containing, by weight, 70 to 60 % molybdenum and 30 to 40 % copper, said rolled composite being formed by impregnating copper into a void between powder particle of molybdenum powder compact, and thereafter primary and secondary rolling in a first and secondary rolling directions once or repeatedly, said first and second directions intersecting to each other, said rolled composite containing powder particles having a flat shape.

According to this invention, there is also provided a ceramic package comprising a heat dissipation substrate made of the above-mentioned material for a semiconductor-mounting heat dissipation substrate of a copper-clad type.

It is here noted that, in this invention, if the impregnating temperature is lower than 1200 °C, Cu has a high viscosity and does not sufficiently infiltrate into the powder compact to leave a void or the like. If the impregnating temperature is higher than 1300 °C, the viscosity of Cu is lowered to cause leakage of Cu which has infiltrated. On the other hand, if the total working rate is lower than 60%, Mo is not sufficiently processed or rolled. This makes it difficult to control the coefficient of linear expansion.

### Brief Description of the Drawings

Fig. 1 is a view showing one example of a ceramic package in which a rolled composite plate according to an embodiment of this invention is mounted;
Fig. 2 is a view showing another example of the ceramic package in which the rolled composite plate according to the embodiment of this invention is mounted;
Fig. 3 is perspective view showing a composite before rolling;
Fig. 4 is an enlarged view of pat A in Fig. 3;
Fig. 5 is a perspective view showing the composite after rolling;
Fig. 6 is an enlarged view of part B in Fig. 5; and
Fig. 7 is a view showing the relationship between the reduction percentage and the coefficient of linear expansion as well as conceptual view of granular structure in each state.

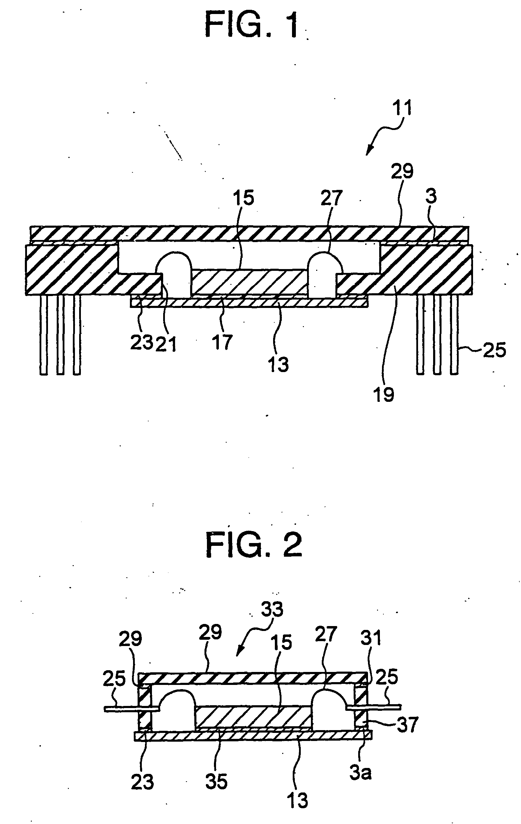

Referring to Fig. 1, a ceramic package 11 uses a copper-clad rolled composite plate or a rolled composite plate as a heat dissipation substrate 13. On the heat dissipation substrate 13, a semiconductor chip 15 is fixed and connected via an adhesive 17. Ceramic 19 as a main body of the ceramic package 11 has an aperture 21 formed at the center of its bottom. Through the aperture 21, the semiconductor chip 15 is inserted into the ceramic 19. A surface of the ceramic 19 outside the aperture 21 and the heat dissipation substrate 13 are bonded through a silver brazing alloy 23. Thus, the ceramic 19 around the semiconductor chip 15 is covered with the heat dissipation substrate 13.

The ceramic 19 is provided with pins 25 protruding on the side of the rolled composite plate 13 as terminals to be connected to a substrate which is not illustrated in the figure or a connector mounted on the substrate. These pins 25 and the semiconductor chip are electrically connected through bonding wires 27. The ceramic 19 and a ceramic lid 29 covering the ceramic are bonded through a low-melting-point glass to enclose the semiconductor chip 15 within the package.

Referring to Fig. 2, a ceramic package 33 has a structure in which the semiconductor chip 15 is bonded onto the rolled composite plate 13 as the heat dissipation substrate via an AuSn solder 35. The heat dissipation substrate 13 with the semiconductor chip 15 mounted thereon is bonded to ceramic 27 via the silver brazing alloy 23 to close one end thereof. Thus, the semiconductor chip 15 is encapsulated in the interior of the ceramic 37. The semiconductor chip 15 is electrically connected through the bonding wires 27 to inner ends of the pins 25 penetrating through side surfaces of the ceramic 37. The ceramic 37 has the other end sealed by bonding the ceramic lid 29 through the low-melting-point glass 31, in the manner similar to the example illustrated in Fig. 1.

Next, the heat dissipation substrate used in Figs. 1 and 2 will be described in detail.

The present inventors have found out that, like the rolled product comprising the composite according to the prior art mentioned above, a material having an extremely small coefficient of thermal expansion at a high temperature can be obtained if heavy rolling exceeding 60% is performed. The rolled product is manufactured in the following manner. Molybdenum powder having an average particle size of 2-4 µm is press-formed at a temperature of 100-200 MPa to obtain a molybdenum powder compact. Into a void between powder particles of the molybdenum powder compact, melted copper is impregnates in a non-oxidizing atmosphere at 1200-1300 °C to obtain a Cu-Mo composite consisting of 70-60% molybdenum in weight ratio, the balance copper. The composite is subjected to primary rolling in one direction at a temperature of 100-300 °C and at a working rate of 50% or more and then to secondary rolling as cold rolling at a working rate of 50% or more in a direction perpendicular in the one direction, thereby obtaining a rolled product with a total working rate of 60% or more. The rolled product has a coefficient of linear expansion of 7.2-8.3 x 10⁻⁶/K at 30-800 °C in the secondary rolling direction.

The rolled product has an extremely small coefficient of thermal expansion because, following an increase in rolling rate, molybdenum particles in the composite are elongated in the rolling direction to change a microstructure of the composite.

In view of the above, a molybdenum-copper composite is rolled at an increased working rate so that a coefficient of thermal expansion is 8.3 x 10⁻⁶/K or less at a temperature not higher than 400 °C. Next, the copper layers having a high thermal conductivity are affixed to both surfaces of the molybdenum-copper composite. As a consequence, a [copper/molybdenum-copper composite/copper] clad material (hereinafter called CPC) is obtained which has a thermal conductivity superior to that of the molybdenum-copper composite and a coefficient of thermal expansion as a clad material not higher than 9.0 x 10⁻⁶/K.

It is assumed that such a rolled composite plate but having a coefficient of thermal expansion of 8.3 x 10⁻⁶/K or more is used as a heat dissipation substrate. In this event, when ceramic such as alumina is silver-brazed for packaging, deformation may be caused or cracks may be produced in a bonded portion or the ceramic itself during heat shrinkage. Thus, the use of the above-mentioned rolled composite plate is inappropriate.

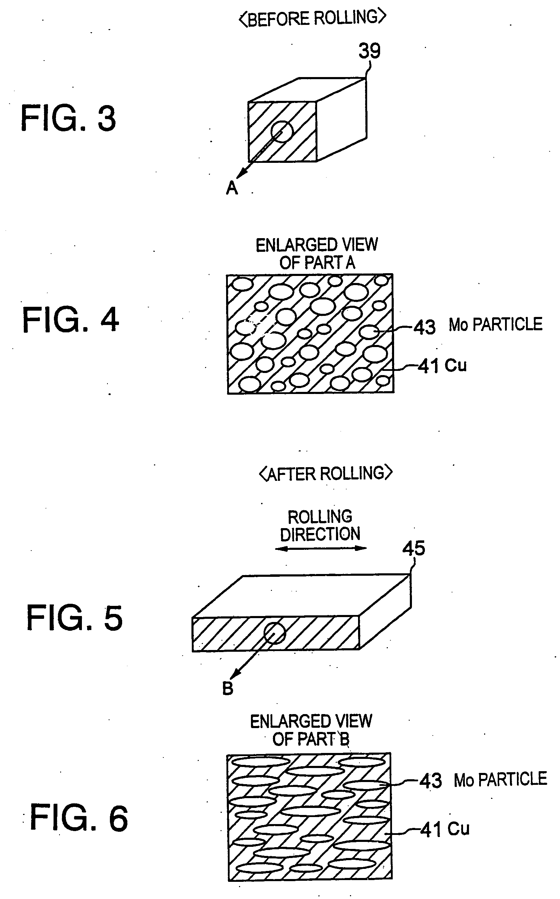

Referring to Figs. 3 and 4, a composite 39 prior to rolling includes circular-section Mo particles 43 dispersed in a matrix of Cu 41. On the other hand, as illustrated in Figs. 5 and 6, a composite 45 after rolling has a structure in which the Mo particles 43 in the matrix of Cu 41 have a collapsed shape flattened in the rolling direction.

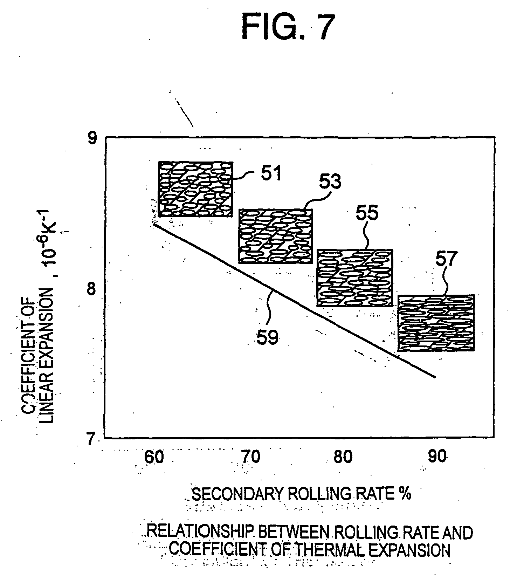

As illustrated in Fig. 7, following the increase in secondary rolling rate, the Mo particles are gradually flattened in the order of reference numerals 51, 53, 55 and 57 and the coefficient of linear expansion is linearly decreased, as depicted by a straight line 59. Thus, the composite material of molybdenum and copper which is produced by the method of this invention can be lowered in coefficient of thermal expansion following the increase in working rate upon rolling.

The CPC produced according to this invention has following characteristics as compares with the CMC.

At first, the intermediate layer comprises the Mo-Cu composite and contains copper. Therefore, it is possible to lower the temperature upon hot rolling for adhesion of the composite to copper. This brings about energy saving and high adhesion force. Because of little difference in deformability between the cladding material and the intermediate layer, deformation on the layers as a result of rolling is small and the quality is stable. The thermal characteristics are superior to those of the CMC because not only heat diffusion is performed in a horizontal (XY) direction but also copper is present in a thickness (Z) direction. As regards the coefficient of thermal expansion, there is no problem because, by controlling the working rate of the Mo-Cu composite material as the intermediate layer without changing the thickness of the Cu layers, the coefficient of thermal expansion of 8.3 x 10⁻⁶/K or less, which allows matching with the ceramic, is obtained. Furthermore, Ni platability is more excellent because less exposure of Mo.

Hereinafter, description will be made of specific examples of production of a rolled composite plate according to this invention.

### Example 1

Molybdenum powder having an average particles size of 4 µm was subjected to hydrostatic press forming at a hydraulic pressure of 150 MPa to form a rectangular plate in dimension of a thickness (T) 12.5 x 180 x 175 mm. A copper plate of T 5 x 175 x 175 mm was put on the rectangular plate and heated in a hydrogen atmosphere at 1300 °C so that copper was melted and impregnated into a void in the molybdenum molded product. Thus, a Cu-Mo composite having a dimension of T 12 x 173 x 168 mm and containing 35 % copper in a weight ration was obtained. The composite was heated to 200 °C and repeatedly subjected to primary rolling at a 20% or less reduction until a predetermined thickness was obtained. Thus, a composite rolled plate of the thickness T₁ x 173 x L mm was formed. Furthermore, secondary rolling (in a crossing direction) was performed at room temperature in a direction perpendicular to the primary rolling direction until T₂ of 1.1 mm is achieved. The list of the results is shown in Table 1. Specifically, rolled composite plates having coefficients of linear expansion of 7.0-8.4 x 10⁻⁶/K at 800 °C were obtained. From these rolled plates A-F, test pieces of 10 x 40 mm were cut out. Each test piece was subjected to nickel plating and than hot-brazed at 850 °C to a ceramic frame containing 99.5% or more Al₂O₃ (after one surface was metallized by tungsten, Ni-plating was performed thereon) by the use of a silver brazing alloy having a silver-copper eutectic composition. Thus, the ceramic package illustrated in Fig. 1 or 2 was produced and the wrap of MO-Cu as a bottom plate was measured. The measured values are shown in Table 2.

As shown in Tables 1 and 2, the wrap is increased in a convex shape when the coefficient of linear expansion exceeds 8.4 x 10⁻⁶/K (rolled plate A). On the other hand, when the coefficient of thermal expansion is smaller than 7.2 x 10⁻⁶/K or less (rolled plates E, F), the wrap is increased in a concave shape. Therefore, the use of the rolled plate A, E or F as a practical substrate caused a defect.

On the other hand, the rolled plates B-D exhibited small wrap and can therefore be used as the substrate without any problem.

**Table 1**

| Type | | | A | B | C | D | E | F |
|---|---|---|---|---|---|---|---|---|
| Primary Thickness T₁ (mm) | | | 3.1 | 3.7 | 3.4 | 5.5 | 8.0 | 12.0 |
| Secondary Thickness T₂ (mm) | | | 1.1 | 1.1 | 1.1 | 1.1 | 1.1 | 1.1 |
| Secondary Rolling Rate (%) | | | 65 | 70 | 75 | 80 | 86 | 91 |
| Coefficient | Secondary | (300-400 °C) | 9.0 | 8.7 | 8.5 | 8.1 | 7.7 | 7.5 |
| of Linear | Rolling Direction | | | | | | | |
| Expansion | | (300-400 °C) | 8.4 | 8.2 | 7.9 | 7.6 | 7.2 | 7.0 |
| Coefficient of Linear Expansion: in 10⁻⁶/K | | | | | | | | |

**Table 2**

| Type | A | B | C | D | E | F |
|---|---|---|---|---|---|---|
| Deformation of Bottom Plate (µm) | +28 - +22 | +13 - +1 | +7 - -15 | -1 - -15 | -23 - -35 | -33 - -45 |
| <+: convex wrap, -: concave wrap> | | | | | | |

### Example 2

According to the conditions in the rolled plate E in Example 1, an impregnated product having a thickness of 18 mm was obtained. The impregnated product was rolled by primary rolling of T₁ of 15 mm and finished by secondary rolling to obtain a Cu-Mo composite having T₂ of 3 mm. The Cu-Mo composite was sandwiched by Cu plates having T of 1 mm and attached to upper and lower surfaces thereof, and held in an electric furnace in a hydrogen atmosphere heated to 800 °C for 15 minutes. The sandwiched composite was made to pass through a roll at a 10% initial reduction (hot rolling) to press-bond Cu and the Cu-Mo composite. It is noted here that the CMC (Cu/Mo/Cu multilayer material) requires heating at 850 °C or more and the initial reduction of 20% or more. Thus, press-bonding of Cu and the Cu-Mo composite is more economical and easier.

Next, surface treatment was performed to remove oxide or the like. Thereafter, rolling was repeatedly carried out at a 10% or less reduction to obtain a clad material of Cu/Cu-Mo composite/Cu having T of 2 mm. At this time, the layer ratio is 1 : 4: 1. Hereinafter, the clad material will be called CPC 141.

The CPC 141 had a coefficient of linear expansion of 8.2 x 10⁻⁶/K at 400 ^C. The rolled plate was processed in the manner similar to example 1 and soldered to a ceramic frame containing AIN to produce a ceramic package like in example 1. As a result, the wrap was as good as +10µm (convex wrap). Any defect such as cracks was not caused in a soldered portion of a ceramic portion.

### Example 3

Under the conditions of the rolled plate D in example 1, rolling was carried out to obtain a Cu-Mo composite having a thickness T of 1.1 mm. The Cu-Mo composite was sandwiched by Cu plates having T of 0.4 mm and attached to upper and lower surfaces thereof and press-bonded by rolling in the manner similar to example 2 to obtain a composite. The composite is a CPC clad material of Cu/Cu.-Mo composite/Cu (layer ration being 1 : 4 : 1) having a thickness T of 1.0 mm. The CPC 141 had a coefficient of linear expansion of 8.2 x 10⁻⁶/K at 800 °C. The rolled plate was processed in the manner similar to example 1 and Ag brazed to a ceramic frame containing Al₂O₃ to produce a ceramic package like in example 1. The wrap of the Mo-Cu bottom plate was measured. As a result, the wrap was as good as +11 µm (convex wrap). Any defect such as cracks was not caused in a brazed portion or a ceramic portion.

### Example 4

Under the conditions of the rolled plate E in example 1, rolling was carried out to obtain a Cu-Mo composite having a thickness of 1.1 mm. The Cu-Mo composite was sandwiched by Cu plates having T of 0.4 mm and attached to upper and lower surfaces thereof and press-bonded by rolling in the manner similar to example 2 to obtain a composite The composite is a CPC clad material of Cu/Cu-MO composite/Cu (layer ration being 1 : 4 : 1 ) having a thickness T of 1.0 mm. The CPC 141 had a coefficient of linear expansion of 7.8 x 10⁻⁶/K at 800 °C. The rolled plate was processed in the manner similar to example 1 and Ag brazed to a ceramic frame containing Al₂O₃ to produce a ceramic package like in example 1. In the ceramic package, the wrap of the Mo-Cu bottom plate was measured. As a result, the wrap was as good a +5 µm (convex wrap). Any defect such as cracks was caused in a brazed portion or a ceramic portion.

As described above, according to this invention, it is possible to provide a semiconductor-mounting heat dissipation substrate which is for use as a heat dissipation substrate of a ceramic package and which is superior in thermal conductivity to a CMC clad material and easy in machining by a punch press and to provide a method of producing the same.

According to this invention, it is also possible to provide a semiconductor-mounting heat dissipation substrate of a copper-clad type, which has a thermal expansion characteristic such that various problems resulting form thermal strain are not caused even if it is brazed with ceramic and to provide a method of producing the same.

According to this invention, it is also possible to provide a ceramic package in which the semiconductor-mounting heat dissipation substrate of a copper-clad type having the above-mentioned advantages is mounted without being subjected to Ni plating.

As described above, the semiconductor-mounting heat dissipation substrate according to this invention is most suitable as the heat dissipation substrate of the ceramic package or the like.

## Claims

1. A material for a semiconductor-mounting heat dissipation substrate, said material being formed from a rolled composite containing, by weight, 70 to 60% molybdenum and 30 to 40% copper, said rolled composite formed by impregnating copper into a void between powder particle of molybdenum powder compact, and thereafter primary and secondary rolling in a first and secondary rolling directions once or repeatedly, said first and second directions intersecting to each other, said rolled composite containing powder particles having a flat shape.

2. A material for a semiconductor-mounting heat dissipation substrate, said substrate being a copper/copper-molybdenum composite/copper clad material formed by press-bonding copper plates to both surface of a rolled composite, said rolled composite rolled composite containing, by weight, 70 to 60% molybdenum and 30 to 40% copper, said rolled composite being formed by impregnating copper into a void between powder particle of molybdenum powder compact, and thereafter primary and secondary rolling in a first and secondary rolling directions once or repeatedly, said first and second directions intersecting to each other, said rolled composite containing powder particles having a flat shape.

3. A ceramic package comprising a heat dissipation substrate made of the material for a semiconductor-mounting heat dissipation substrate of a copper-clad type claimed in Claim 2.
